# FASCICULE DE BREVET EUROPEEN

(11) **EP 2 161 238 B1**
(45) Date de publication et mention de la délivrance du brevet: **08.06.2011**
(21) Numéro de dépôt: 09169175.8
(22) Date de dépôt: 01.09.2009
(51) Int. Cl.: B81B 3/00, H01M 8/10, H01L 29/92

(54) **Structure tridimensionnelle très haute densité**
Dreidimensionale Struktur mit sehr hoher Dichte
Very high-density three-dimensional structure

(30) Priorité: 03.09.2008 FR 0855906
(43) Date de publication de la demande: 10.03.2010
(73) Titulaire: STMicroelectronics (Tours) SAS, 37100 Tours (FR)
(72) Inventeur: Morand, Jean-Luc, 37100, TOURS (FR)
(74) Mandataire: de Beaumont, Michel

(56) Documents cités:
- DE-U1-202007 003 877
- US-A- 3 962 713
- HONG ET AL: "Conjugate heat transfer in fractal-shaped microchannel network heat sink for integrated microelectronic cooling application" INTERNATIONAL JOURNAL OF HEAT AND MASS TRANSFER, PERGAMON PRESS, GB, vol. 50, no. 25-26, 5 novembre 2007 (2007-11-05), pages 4986-4998, XP022371447 ISSN: 0017-9310
- HIRAD SAMAVATI ET AL: "Fractal Capacitors" IEEE JOURNAL OF SOLID-STATE CIRCUITS, IEEE SERVICE CENTER, PISCATAWAY, NJ, US, vol. 33, no. 12, 1 décembre 1998 (1998-12-01), XP011060899 ISSN: 0018-9200

## Description

### Domaine de l'invention

La présente invention concerne des structures tridimensionnelles et, plus particulièrement, des supports pour de telles structures. La présente invention concerne des structures dont au moins une dimension est de l'ordre du micromètre, voire de quelques dixièmes de micromètres ou moins.

### Exposé de l'art antérieur

Pour former des structures tridimensionnelles, une méthode consiste à utiliser un substrat, par exemple de silicium, dans lequel on forme de nombreuses tranchées très étroites et proches les unes des autres, par exemple à un pas de l'ordre du micromètre, séparées par des lamelles de silicium. On forme ainsi par exemple des dispositifs micro-électro-mécaniques (MEMS). Sur les parois et le fond de ces tranchées peuvent également être disposées diverses couches pour former des composants électroniques. On peut également former des coeurs de piles à combustible ou encore des cellules formant des micro-batteries sur les parois et le fond de ces tranchées.

Dans le cas des composants électroniques, on forme par exemple des condensateurs ou des diodes dont les zones actives s'étendent sur les parois et le fond des tranchées. Ainsi, on obtient des condensateurs ayant des capacités par unité de surface très élevées.

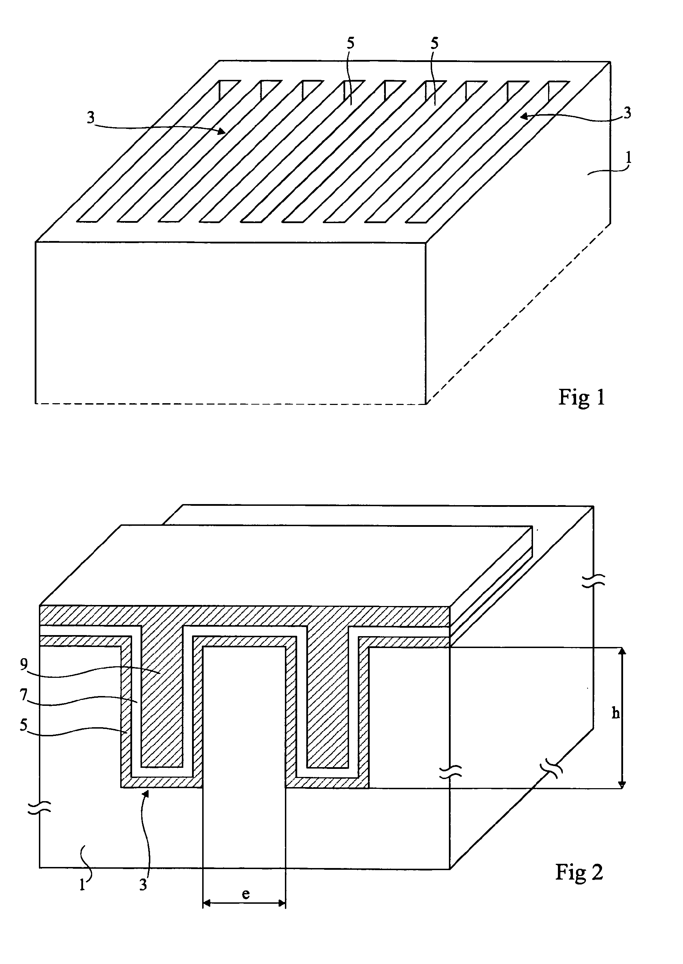

La figure 1 illustre un exemple d'un support pour des composants tridimensionnels. Le support est constitué d'un substrat 1, par exemple de silicium, dans lequel sont formées des tranchées 3. Les tranchées 3 ont une forme, en surface du substrat, rectangulaire et fortement allongée. Les tranchées s'étendent parallèlement les unes aux autres. Ainsi, chaque tranchée 3 est séparée d'une autre tranchée par une lamelle de silicium 5. Le brevet américain US3962713 divulgue un tel support.

La figure 2 illustre une vue partielle en coupe d'un condensateur formé sur un support tel que celui de la figure 1. En figure 2, seules deux tranchées 3 sont représentées.

Sur la surface du substrat 1 et sur les parois et le fond des tranchées 3 s'étend un empilement d'une première couche conductrice 5 et d'une couche isolante 7. Une seconde couche conductrice 9 remplit l'espace restant dans les tranchées 3 et s'étend, au-dessus du substrat, sur la couche isolante 7. Les couches conductrices 5 et 9 constituent les deux électrodes du condensateur. Des contacts, non représentés, sont pris de façon appropriée sur chacune de ces électrodes.

La capacité du condensateur de la figure 2 est liée à la surface en regard entre chacune des électrodes 5 et 9 et à l'épaisseur de la couche isolante 7. Un objectif récurrent dans la réalisation des condensateurs tridimensionnels est d'augmenter leurs capacités sans augmenter la surface qu'ils occupent en surface du substrat. On cherche donc à augmenter la surface en regard entre les électrodes. Pour cela, il est souhaitable d'augmenter la hauteur h et de diminuer l'épaisseur e des lamelles entre tranchées pour former plus de tranchées par unité de surface.

Cependant, lorsque l'on creuse trop profondément ou que l'on forme des tranchées très proches, il apparaît, sur chacune des lamelles séparant les tranchées, des contraintes mécaniques qui peuvent déformer les lamelles et les tranchées. Ceci limite l'augmentation du rapport entre la profondeur des tranchées et l'épaisseur des lamelles.

### Résumé

La présente invention vise des supports pour des structures tridimensionnelles ayant une densité d'intégration importante, susceptibles de comporter des lamelles hautes et minces.

La présente invention vise également tout type de composant mécanique, électronique ou autre, formé sur un tel support.

Ainsi, pour atteindre tout ou partie de ces objets ainsi que d'autres, la présente invention prévoit une structure tridimensionnelle selon la revendication 1.

Selon un mode de réalisation de la présente invention, l'ensemble des tranchées séparant les lamelles forme, en surface du substrat, un motif suivant une courbe fractale de Moore.

Selon la présente invention, l'évidement a une profondeur, dans le substrat, supérieure à 100 µm.

Selon la présente invention, les lamelles ont une épaisseur inférieure à 0,8 µm et sont séparées les unes des autres d'une distance inférieure à 0,8 µm.

Selon un mode de réalisation de la présente invention, le substrat et les lamelles sont en silicium.

Un mode de réalisation de la présente invention prévoit en outre un dispositif comprenant une structure telle que décrite ci-dessus sur le relief de laquelle s'étend un condensateur, une diode, une pile à combustible ou une micro-batterie.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, illustre un exemple de support connu de composants tridimensionnels ;
la figure 2, précédemment décrite, illustre un exemple de condensateur formé sur un support tel que celui de la figure 1 ;
les figures 3A et 3B illustrent l'effet des phénomènes de flambage sur une lamelle de silicium ;
les figures 4A et 4B illustrent l'effet des forces électrostatiques entre deux lamelles de silicium ;
les figures 5A et 5B illustrent, en vue de dessus, deux motifs susceptibles d'être soumis à des déformations mécaniques ;
la figure 6 est une vue de dessus d'un support selon un mode de réalisation de la présente invention ; et
la figure 7 est une vue de dessus d'un autre support selon un mode de réalisation de la présente invention.

### Description détaillée

Par souci de clarté, de mêmes éléments ont été désignés par de mêmes références aux différentes figures et, de plus, les diverses figures ne sont pas tracées à l'échelle.

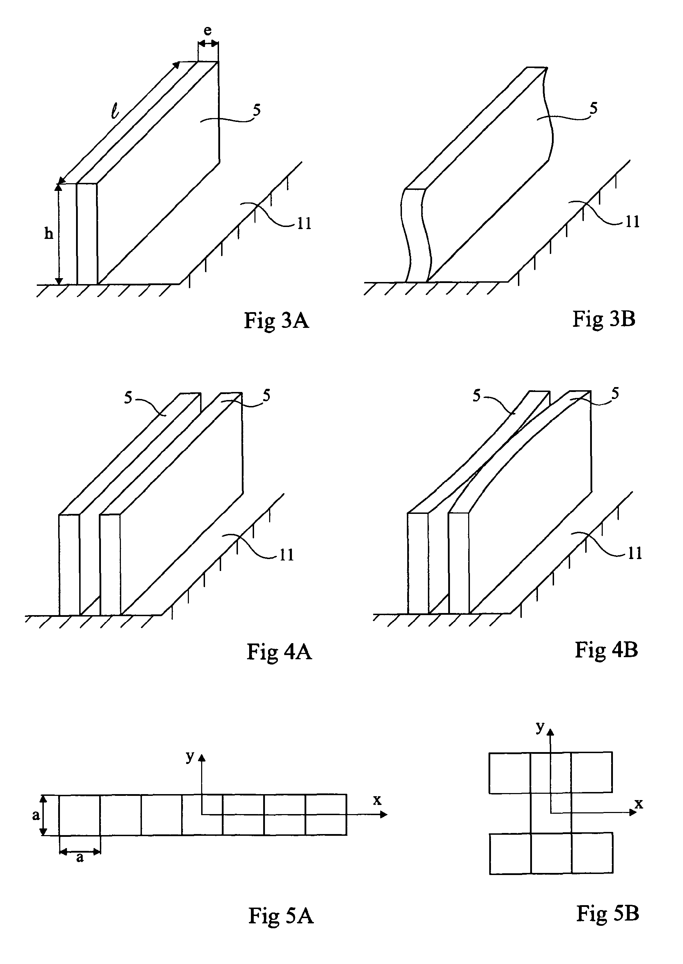

Les figures 3A, 3B, 4A et 4B illustrent les effets de deux contraintes mécaniques qui apparaissent sur des lamelles lorsque celles-ci ont une hauteur importante ou une faible épaisseur. Plus particulièrement, les figures 3A et 3B illustrent les déformations dues au flambage et les figures 4A et 4B les déformations dues aux forces électrostatiques entre les lamelles.

La figure 3A illustre une lamelle 5 isolée s'étendant verticalement à partir d'un plan 11. La lamelle 5 a une hauteur h, une épaisseur e et une longueur 1.

Lorsque la hauteur h de la lamelle est grande et que son épaisseur e est faible, un phénomène de flambage peut se produire du fait du poids de la lamelle. Il en résulte la déformation de la lamelle, comme cela est illustré en figure 3B : la lamelle s'affaisse sur elle-même, sa hauteur h diminue et la forme en coupe de celle-ci est sensiblement en S ou en C.

La figure 4A illustre deux lamelles 5 parallèles, du même type que celle de la figure 3A. La figure 4B illustre la déformation des lamelles de la figure 4A due aux forces électrostatiques qui s'exercent entre ces lamelles. La base des lamelles 5 étant fixée au support 11, les forces électrostatiques amènent les deux parois en regard des deux lamelles à se rapprocher, voire à se toucher, comme cela est représenté en figure 4B.

La formation de lamelles ayant une hauteur h importante et une faible épaisseur e augmente les risques de déformation de ces lamelles sous les effets mentionnés ci-dessus. Ainsi, les phénomènes parasites mécaniques et électrostatiques limitent les possibilités de choix dimensionnels.

On prévoit de former un support comprenant des lamelles ayant une forme telle que les phénomènes de flambage et les déformations dues aux forces électrostatiques sont atténués. Pour cela, l'inventeur propose de former, dans le support, des ensembles de lamelles. Chaque ensemble comporte un assemblage de lamelles orthogonales dont au moins une rejoint une paroi d'un évidement dans lequel sont formés les ensembles de lamelles. Ainsi, on peut définir, dans chaque assemblage, des portions ayant, en vue de dessus, des formes sensiblement de I.

Dans une portion en I comportant une barre centrale et deux branches extrêmes parallèles, les lamelles formant les branches parallèles du I permettent le maintien de la lamelle formant la barre centrale de celui-ci. La rigidité d'un ensemble de lamelles, comme toute structure mécanique, est caractérisée par son moment quadratique. Celui-ci est particulièrement élevé dans le cas de portions en I.

La figure 5A représente un exemple de lamelle constituée de sept carrés élémentaires de côté a s'étendant selon un axe x. Le périmètre de cette lamelle vaut donc 16a. La figure 5B illustre un ensemble de lamelles formant un I comprenant également sept carrés élémentaires de côté a. Cet ensemble a également un périmètre égal à 16a. Ainsi, la surface de couches formées sur les parois des lamelles sera la même dans le cas des figures 5A et 5B. En figure 5B, un axe y suit la direction de la barre centrale du I et un axe x est perpendiculaire à l'axe y. La théorie montre que le moment quadratique selon l'axe x de la lamelle de la figure 5A est environ 11 fois plus petit que le moment quadratique selon l'axe x de la forme en I de la figure 5B et environ 10 fois plus petit que le moment quadratique selon l'axe y de ce dernier motif. Cette différence de moments quadratiques explique la différence de rigidité entre les motifs des figures 5A et 5B.

Pour augmenter encore la résistance des ensembles de lamelles aux phénomènes mécaniques et électrostatiques, l'inventeur prévoit que chaque ensemble de lamelles comporte au moins une lamelle qui est connectée directement à une paroi d'un évidement dans lequel sont formées les différents ensembles de lamelles. L'homme de l'art pourra facilement former une telle structure comprenant des ensembles de lamelles perpendiculaires entre elles, chaque ensemble comprenant au moins une lamelle connectée à une paroi de l'évidement.

Parmi les différentes configurations possibles, l'inventeur propose de réaliser des tranchées ayant une forme, en vue de dessus, suivant sensiblement une courbe fractale de Moore. Une telle courbe fractale a l'avantage de s'inscrire naturellement dans un carré, ce qui se prête particulièrement bien à la géométrie des puces électroniques, et de pouvoir être facilement modélisée par ordinateur.

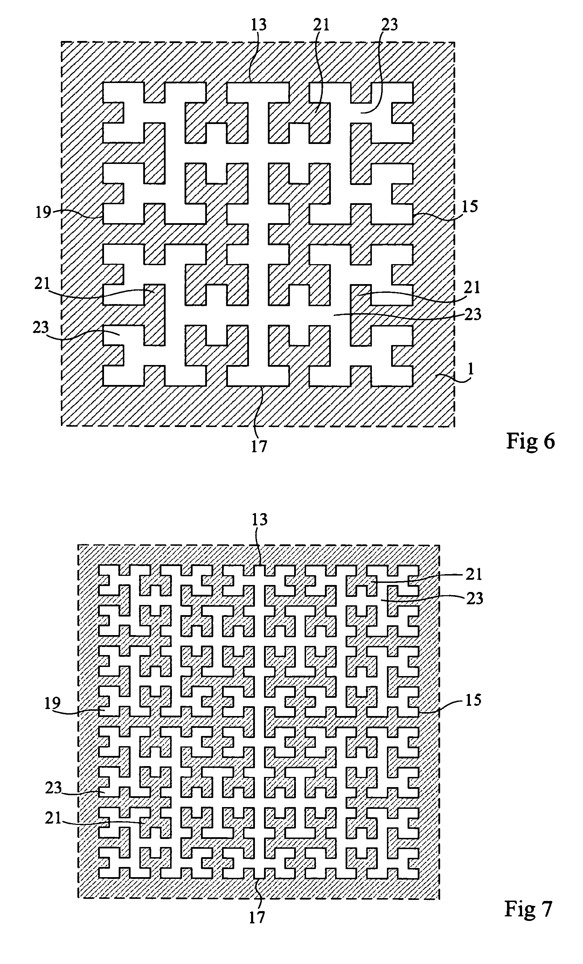

La figure 6 est une vue de dessus d'un support selon un tel mode de réalisation, ce support étant par exemple en silicium. Le support 1 comprend un évidement délimité par des parois 13, 15, 17 et 19. Des lamelles 21 s'étendant à partir du fond de l'évidement entourent des tranchées 23, l'ensemble des tranchées 23 formant un motif suivant une courbe de Moore d'ordre 4. Chaque lamelle 21 est soit directement connectée à l'une des parois 13, 15, 17 ou 19, soit indirectement connectée à l'une de ces parois par l'intermédiaire d'une ou de plusieurs lamelles 21, perpendiculaires à la première lamelle. On obtient ainsi une structure rigide, chaque lamelle permettant un maintien efficace des lamelles qui l'entourent.

La figure 7 illustre une variante de la figure 6 dans laquelle les tranchées 23 suivent une courbe de Moore d'ordre 5.

Avantageusement, pour une même surface de substrat et des lamelles de mêmes épaisseurs, une structure telle que celle de la figure 6 a une résistance mécanique 5 à 10 fois supérieure à celle d'une structure telle que celle de la figure 1. Ainsi, on peut former des tranchées ayant une hauteur au moins 5 fois plus importante que précédemment, sans risquer de détériorer la rigidité de la structure. Les lamelles pourront avoir une épaisseur bien inférieure au micromètre, par exemple de 0,8 µm, voire inférieure au dixième de micromètre, pour une hauteur supérieure à 100 µm, et être séparées d'une distance inférieure au micromètre, par exemple de 0,8 µm, voire inférieure au dixième de micromètre. Dans le cas de condensateurs, on obtient, pour une même surface de substrat, des condensateurs ayant des capacités au moins 5 fois plus importantes que précédemment. L'inventeur prévoit d'obtenir des condensateurs ayant une capacité par unité de surface supérieure à environ 250 nF/mm².

On notera que les réalisations des figures 6 et 7 ne sont que des exemples, et que tout motif comprenant des lamelles dont les ensembles forment sensiblement des portions de I et dont chaque ensemble comprend au moins une lamelle directement connectée à une paroi du support, conviendra également.

On pourra également utiliser des versions arrondies des courbes de Moore qui ne présentent aucun angle vif, pour des facilités de réalisation. Ceci s'apparente à des formes de type IPN (poutrelles à profil normal) dont la particularité est de bien résister à des efforts désaxés. De telles structures sont formées sur une base de I dans laquelle les branches extrêmes du I sont élargies au niveau de la barre centrale de celui-ci. De telles structures permettent encore d'augmenter la résistance mécanique des motifs formés sur un substrat de silicium.

## Revendications

1. Structure tridimensionnelle formée dans un évidement d'un substrat délimité par des parois (13, 15, 17, 19), comprenant un grand nombre de lamelles parallélépipédiques rectangle (21) s'étendant à partir du fond de l'évidement jusqu'à la surface du substrat en étant orientées perpendiculairement les unes aux autres et selon un motif occupant toute la surface dudit évidement, certaines lamelles étant non sécantes à l'une des parois, chaque lamelle non sécante étant reliée à l'une des parois par au moins une autre lamelle perpendiculaire, l'évidement présentant une profondeur, dans le substrat, supérieure à 100 µm, les lamelles (21) présentant une épaisseur inférieure à 0,8 µm et étant séparées les unes des autres d'une distance inférieure à 0,8 µm.

2. Structure selon la revendication 1, dans laquelle l'ensemble des tranchées (23) séparant les lamelles (21) forme, en surface du substrat, un motif suivant une courbe fractale de Moore.

3. Structure selon la revendication 1 ou 2, dans laquelle le substrat et les lamelles (21) sont en silicium.

4. Dispositif comprenant une structure selon l'une quelconque des revendications 1 à 3, sur le relief de laquelle s'étend un condensateur, une diode, une pile à combustible ou une micro-batterie.

## Claims

1. A 3-D structure formed in a recess of a substrate delimited by walls (13, 15, 17, 19), comprising a large number of parallelepipedic thin blades (21) extending from the bottom of the recess to the substrate surface while being oriented perpendicularly to one another, some blades being non-secant to one of the walls, each non-secant blade being connected to one of the walls by at least another perpendicular blade, the recess having a depth, in the substrate, which is greater than 100 µm, the blades (21) having a thickness smaller than 0.8 µm and being separated from one another by a distance shorter than 0.8 µm.

2. The structure of claim 1, wherein the set of trenches (23) separating the blades (21) altogether forms, at the substrate surface, a pattern following a Moore fractal curve.

3. The structure of claim 1 or 2, wherein the substrate and the blades (21) are made of silicon.

4. A device comprising the structure of any of claims 1 to 3, on the surface of which extends a capacitor, a diode, a fuel cell, or a power microcell.

## Patentansprüche

1. Eine 3-D-Struktur gebildet in einer Ausnehmung eines Substrats begrenzt durch Wände (13, 15, 17, 19), wobei folgendes vorgesehen ist:
eine große Anzahl von parallelepipedförmigen dünnen Platten (21), die sich, während sie senkrecht zueinander orientiert sind, von dem Boden der Ausnehmung zur Substratoberfläche erstrecken, wobei einige Platten bezüglich einer der Wände nicht schneidend vorgesehen sind, wobei jede nicht schneidende Platte mit einem der Wände durch mindestens eine weitere senkrechte Platte verbunden ist, wobei die Ausnehmung eine Tiefe in dem Substrat aufweist, die größer ist als 100 µm und wobei die Platten (21) eine Dicke kleiner als 0,8 µm besitzen und die voneinander um einen Abstand kürzer als 0,8 µm getrennt sind.

2. Die Struktur bzw. Gebilde nach Anspruch 1, wobei der Satz von Gräben (23) die die Platten (21) trennen zusammen an der Substratoberfläche ein Muster bilden, welches einer Moore-Kurve (Moore fractal curve) folgt.

3. Struktur oder Gebilde nach Anspruch 1 oder 2, wobei das Substrat und die Platten (21) aus Silizium hergestellt sind.

4. Eine Vorrichtung, die die Struktur eines der Ansprüche 1 bis 3 aufweist, wobei sich auf der Oberfläche derselben ein Kondensator, eine Diode und eine Brennstoffzelle oder eine Leistungsmikrozelle erstreckt.
